# EUROPEAN PATENT APPLICATION

(11) **EP 2 312 650 A2**
(43) Date of publication of application: **20.04.2011**
(21) Application number: 10187420.4
(22) Date of filing: 13.10.2010
(51) Int. Cl.: H01L 31/18, C23C 16/455

(54) **Solar Cell and Method of Fabricating the Same**

(30) Priority: 13.10.2009 KR 20090097453; 17.09.2010 KR 20100091851
(71) Applicant: IPS Ltd, Pyungtaek Si, Gyeonggi-do 450-090 (KR)
(72) Inventor: Park, Sang-Joon, 448-130, Gyeonggi-do (KR); Park, Seong-Beom, 459-020, Gyeonggi-do (KR); Kim, Young-Jun, 459-020, Gyeonggi-do (KR); Bae, Jun-Sung, 134-063, Gangdong-gu, Seoul (KR)
(74) Representative: Herzog, Markus

(57) **Abstract**

A solar cell and a fabricating method thereof are provided. In the method of fabricating the solar cell, a p-type semiconductor substrate on whose light-receiving surface an antireflection coating is formed is loaded into a processing chamber. In this case, the p-type semiconductor substrate may be loaded on a substrate support of an apparatus of processing a plurality of substrates along the circumference of the substrate support, in the state where the back surface of the p-type semiconductor substrate faces upward. Then, a back surface field (BSF) layer having the characteristic of Negative Fixed Charge (NFC) is formed with AlO, AlN or ALON on the back surface of the p-type semiconductor substrate. At this time, the BSF layer may be formed by simultaneously injecting an A1 source gas, a first purge gas, an oxidizing agent gas and/or a ntiriding agent gas, and a second purge gas through injection holes of individual gas injection units while relatively rotating the substrate support with respect to the shower head. Thereafter, a back surface electrode is formed on the BSF layer such that the back surface electrode is electrically connected to the BSF layer.

## Description

### CROSS-REFERENCE TO RELATED APPLICATION

This application claims the benefit under 35 U.S.C. §119(a) of Korean Patent Applications No. 10-2009-0097453, filed on October 13, 2009 and No. 10-2010-0091851, filed on September 17, 2010, the entire disclosure of which is incorporated herein by reference for all purposes.

### BACKGROUND

### 1. Field

The following description relates to a solar cell and a method of fabricating the same.

### 2. Description of the Related Art

A solar cell having a p-n junction structure is a semiconductor device which converts solar energy into electrical energy. In the p-n junction structure, diffusion due to concentration gradient of carriers occurs between a p-type semiconductor region and a n-type semiconductor region, and the diffusion of carriers changes space charges to form an electric field in the p-n junction structure. When the diffusion components of the carriers are equal to drift components caused by the electric field, the p-n junction structure becomes in equilibrium. In the equilibrium of the p-n junction structure, when photons having energy exceeding a bandgap of a p-n junction diode are incident to the p-n junction structure, electrons that have received the light energy are excited from a valence band to a conduction band. As a result, electron-hole pairs are created and current is generated from the solar cell by flowing the electrons and holes separatedly through both terminals of a p-n junction diode connected to an external circuit.

In order to increase the efficiency of a solar cell, that is, the opto-electric conversion efficiency of a solar cell, it is needed to increase the amount of electron-hole pairs that are generated by light. In order to increase the amount of electron-hole pairs, the p-n junction diode has to be fabricated with a material having an excellent opto-electric conversion property. Also, it is possible to increase the amount of electron-hole pairs by lengthening a transfer path of solar light in the p-n junction diode as possible. As another method, by reducing light reflection against the surface of a solar cell to absorb a large amount of solar light into a p-n junction diode, the opto-electric conversion efficiency may be improved.

Another method for improving the efficiency of a solar cell is to prevent or supress the recombination of electron-hole pairs generated on the surface of or in a p-n junction diode. If a part of electron-hole pairs disappear due to the recombination of the electron-hole pairs although a large amount of electron-hole pairs have been generated, the opto-electric conversion efficiency of a solar cell will be lowered. In order to prevent the recombination of electrons with holes, forming a film for moving generated electrons and holes separatedly to both terminals of a p-n junction diode in a solar cell or lengthening the lifetime of generated electrons and holes is needed.

Conventionally, in order to increase the efficiency of a solar cell, a method of forming fine concavo-convexes in the front side of the solar cell, forming an anti-reflection coating with SiNₓ thereon and then forming a back surface field (BSF) layer with Al paste on the back side of the solar cell has been used. The fine concavo-convexes and the anti-reflection coating act to lower the reflectance of solar light on the light-receiving surface of the solar cell. Additionally, the anti-reflection coating acts to lower speed at which carriers generated in the front side of the solar cell are recombined, and the back side field layer formed with Al paste acts to lower speed at which carriers generated in the back side of the solar cell are recombined.

However, the conventional solar cell has limitation in improvement of the opto-electric conversion efficiency. The reason is because a sufficient amount of electron-hole pairs generated by solar light may fail to move to electrodes and specifically, a relatively large amount of carriers are recombined in the back side of the solar cell due to an insufficient electric field of the BSF layer formed with Al paste. Furthermore, in the conventional solar cell, the transfer path of photons incident in the solar cell is short, which further reduces the generation efficiency of electron-hole pairs.

### SUMMARY

The following description relates to a solar cell that can achieve high opto-electric conversion efficiency.

Also, the following description relates to a method of fabricating a solar cell that can achieve high opto-electric conversion efficiency.

In one general aspect, there is provided a solar cell including: a p-type semiconductor substrate; a back surface field (BSF) layer formed with Al compound on an opposite surface of a light-receiving surface of the p-type semiconductor substrate; and a back surface electrode formed on the BSF layer to electrically connect to the BSF layer.

In another general aspect, there is provided a method of fabricating a solar cell including: preparing a p-type semiconductor substrate; forming a back surface field (BSF) layer with Al compound on an opposite surface of a light-receiving surface of the p-type semiconductor substrate; and forming a back surface electrode on the BSF layer to electrically connect to the BSF layer.

Other features and aspects will be apparent from the following detailed description, the drawings, and the claims.

### BRIEF DESCRIPTION OF THE DRAWINGS

FIG. 1 is a cross-sectional view illustrating an example of a solar cell.
FIG. 2 is a graph showing comparison results between External Quantum Efficiency (EQE) of a solar cell whose back surface field (BSF) layer is an AlO film and EQE of a solar cell whose BSF layer is Al paste.
FIG. 3 is a cross-sectional view illustrating a modification example of the solar cell illustrated in FIG. 1.
FIGS. 4A through 4E are cross-sectional views for explaining an example of a method of fabricating a solar cell.
FIG. 5 illustrates an example of a single substrate processing apparatus which can be used to form a BSF layer.
FIG. 6 is a timing chart regarding process gases for forming an AlO film using an atomic layer deposition (ALD) process.
FIG. 7 is a view for explaining an example where process gases for forming an AlO film are injected through a shower head whose injection holes are grouped into several gas injection parts in the AID process.
FIG. 8 illustrates an example of a multiple substrate processing apparatus.
FIGS. 9A and 9B illustrate a structure of the multiple substrate processing apparatus.
FIGS. 10A and 10B illustrate a structure of another example of a multiple substrate processing apparatus apparatus.

Throughout the drawings and the detailed description, unless otherwise described, the same drawing reference numerals will be understood to refer to the same elements, features, and structures. The relative size and depiction of these elements may be exaggerated for clarity, illustration, and convenience.

### DETAILED DESCRIPTION

The following description is provided to assist the reader in gaining a comprehensive understanding of the methods, apparatuses, and/or systems described herein. Accordingly, various changes, modifications, and equivalents of the methods, apparatuses, and/or systems described herein will be suggested to those of ordinary skill in the art. Also, descriptions of well-known functions and constructions may be omitted for increased clarity and conciseness.

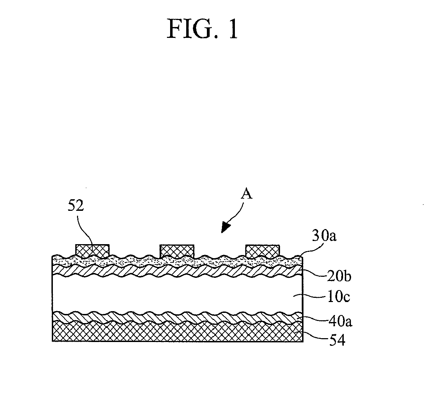

FIG. 1 is a cross-sectional view illustrating an example of a solar cell A.

Referring to FIG. 1, the solar cell A includes a semiconductor substrate 10c on whose upper layer a diffusion layer 20b is formed, for example, a p-type silicon (Si) substrate. The diffusion layer 20b may be formed by injecting impurities such as phosphorous into the semiconductor substrate 10c. The semiconductor substrate 10c may be a monocrystal semiconductor substrate, a polycrystalline semiconductor substrate or an amorphous semiconductor substrate.

An anti-reflection coating 30a is formed on the diffusion layer 20b. The anti-reflection coating 30a may be made of SiNₓ, but not limited to this. A upper electrode pattern 52 is formed on the anti-reflection coating 30a, and the upper electrode pattern 52 may form an ohmic contact with the diffusion layer 20b. The upper electrode pattern 52 may be made of a conductive material such as Ag, Cu or the like. Light-receiving layers of the solar cell A, for example, the surfaces of the semiconductor substrate 10c, the diffusion layer 20b and the anti-reflection coating 30a have a fine concavo-convex structure to widen light-receiving areas, thus increasing absorptivity of incident sunlight.

A back surface field (BSF) layer 40a is formed on the opposite surface of the light-receiving surfaces of the semiconductor substrate 10c, that is, on a back surface of the semiconductor substrate 10c. The BSF layer 40a may be a single layer film made of aluminum compound, for example, AlO. Or, the BSF layer 40a may be a single layer file made of AlN or AlON or a composite film made of AlN and AlON. The BSF layer 40a functions to prevent efficiency deterioration by the recombination of electrons with holes in the back side, specifically, in the interface between the semiconductor substrate 10c and BSF layer 40a, and the BSF layer 40a also functions as a passivation layer. A back surface electrode 54 is formed on the BSF layer 40a. The back surface electrode 54 may be formed with Al paste, however, not limited to this.

As described above, the BSF layer 40a may be an AlO, AlN and/or AlON film. In this case, the BSF layer 40a has the characteristic of Negative Fixed Charge (NFC). However, all of AlO, AlN and AlON films do not have the NFC characteristic and only AlO, AlN and AlON films formed using the Atomic Layer Deposition (ALD) or Chemical Vapor Deposition (CVD) process at the temperature range of 150 - 400 °C have a sufficient NFC characteristic. The BSF layer 40a having the NFC characteristic moves electrons toward the front side of the solar cell A to prevent the electrons from moving toward the back side and also facilitates moving holes toward the back side of the solar cell A. A BSF formed by an AlO film or the like is stronger than a BSF formed by Al paste, which lengthens the lifetime of electron-hole pairs.

Also, the BSF layer 40a formed with AlO, AlO and/or AlON improves internal reflection efficiency with respect to light transmitted into the solar cell A, specifically, long wavelength light longer than 900 nm. An increase of internal reflection efficiency of light lengthens the moving path of photons and accordingly increases the amount of electron-hole pairs created in the juction of the semiconductor substrate 10c and diffusion layer 20b. As a result, the solar cell has high Internal Quantum Efficiency (IQE) compared to existing solar cells. The IQE represents opto-electric conversion efficiency of photons that are incident in a bulk.

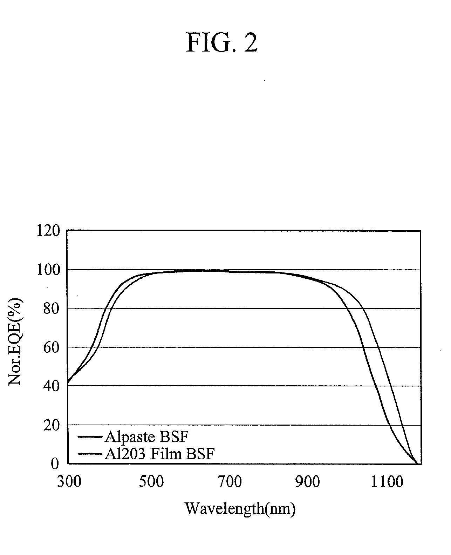

As such, the fact that the BSF layer 40a formed with Al compound has more excellent reflection efficiency than a BSF layer formed with Al paste can be verified from the measurement results with respect to External Quantum Efficiency (EQE). The EQE represents incident efficiency of photons. FIG. 2 is a graph showing comparison results between EQE of the solar cell A whose BSF layer 40a is an AlO film and EQE of a solar cell whose BSF layer is formed with Al paste. It is seen from FIG. 2 that the solar cell A has higher EQE than the existing solar cell in a long wavelength region above 900nm.

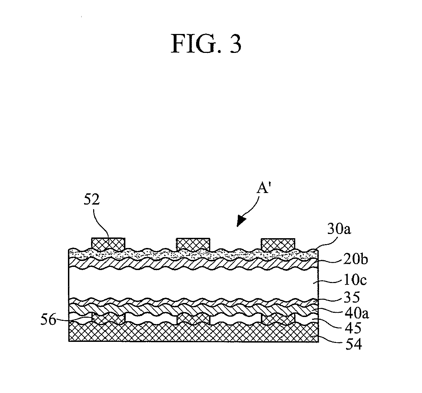

FIG. 3 is a cross-sectional view illustrating a modification example A' of the solar cell A illustrated in FIG. 1. The solar cell A' includes a semiconductor substrate 10c, a diffusion layer 20b, an anti-reflection coating 30a, a BSF layer 40a formed with AlO, and a back surface electrode 54, like the solar cell A illustrated in FIG. 1, and further includes a protective layer 35 and a capping layer 45, unlike the solar cell A. The solar cell A' may include any one or both of the protective layer 35 and capping layer 45. Hereinafter, the solar cell A' will be described based on differences from the solar cell A.

Referring to FIG. 3, in the solar cell A', there is provided the protective layer 35 between the semiconductor substrate 10c and the BSF layer 40a formed with AlO. The protective layer 35 may be formed with oxide such as SiO₂. The protective layer 35 is formed in consideration that the interfacial characteristic between the semiconductor substrate 10c and the BSF layer 40a has great influence on the NFC characteristic of the BSF layer 40a when the BSF layer 40a is an AlO film. That is, the protective layer 35 removes defects that exist on the surface of the semiconductor substrate 10c to maximize the NFC characteristic of the AlO film. For this, the protective layer 35 may be formed as an oxide film having excellent quality. For example, the oxide film may be formed using a thermal oxidation process that uses a high temperature over 900°C or using any other well-known process.

The capping layer 45 is provided between the BSF layer 40a formed with AlO and the back surface electrode 54. If the back surface electrode 54 made of A1 paste is formed just on the AlO film, a phenomenon that the AlO film disappears in the interface may occur, which weakens the NFC characteristic of the BSF layer 40a The capping layer 45 prevents the AlO film from directly contacting the Al paste. The capping layer 45 may be formed with an insulting material, such as SiNₓ, SiO₂, SiON or the like. In this case, through contacts 56 for electrical connections between the AlO film (the BSF layer 40a) and the back surface electrode 54 may be formed in the capping layer 45. The through contacts 56 may be formed with Al paste that is the same material as the back surface electrode 54, however, not limited to this.

Meanwhile, as described above, the BSF layer 40a may be a single layer film made of any other Al compound, for example, AlN or AlON, or a composite film made of AlN and AlON. The BSF layer 40a including the AlN film and/or AlON film has the NFC characteristic, like the AlO film, and also functions as a passivation layer. The BSF layer 40a including an AlN film and/or AlON film may be formed on the semiconductor substrate 10c without including any protective layer (for example, the protective layer 35) therebetween. In other words, when the BSF layer 40a is formed with AlN or AlON, the NFC characteristic or the function as a passivation layer of the AlO film and/or the AlON film do not deteriorate although no protective layer made of oxide is provided between the BSF layer 40a and semiconductor substrate 10C. Accordingly, when the BSF layer 40a is formed with AlO and/or AlON, the BSF layer 40a can have an excellent characteristic without performing any additional process for forming a protective layer or a high temperature process (up to 900°C). The AlO or AlON film may be formed using an ALD, CVD, Plasma Enhanced ALD (PEALD), Radical Assisted CVD (RA-CVD) or RA-ALD process.

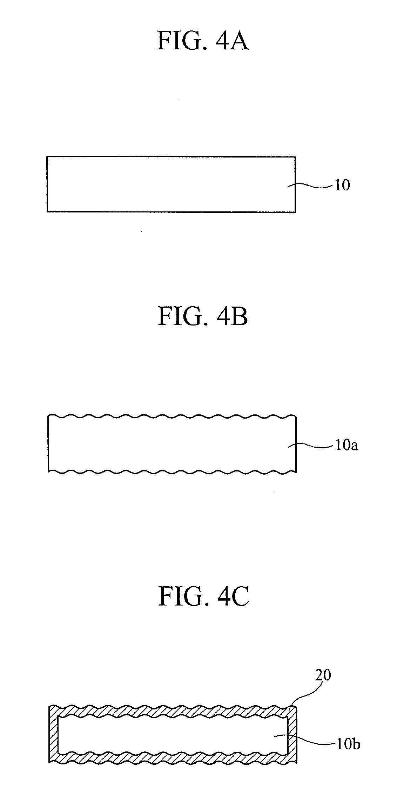

Now, a method of fabricating the solar cell A will be described. FIGS. 4A through 4E are cross-sectional views for explaining an example of a method of fabricating the solar cell A. The method may be also applied to fabricate the solar cell A' illustrated in FIG. 3 by adding a process of forming the protective layer 35, the capping layer 45 and the through contacts 56. The method will be described based on the case where the BSF layer 40a is an AlO film, however, the method can be also applied to the case where the BSF layer 40a is an AlO film and/or AlON film.

Referring to FIG. 4A, a p-type semiconductor substrate 10 is prepared. The p-type semiconductor substrate 10 may be formed by cutting monocrystal silicon ingot created by the Czochralski (CZ) method, polycrystalline silicon ingot created by the cast method, etc. into thin pieces using diamond or a wire saw. A general semiconductor wafer has a circular shape, but a semiconductor wafer for solar cell generally has a quadrangular shape. However, in the current example, the shape of the p-type semiconductor substrate 10 is not limited.

Then, referring to FIG. 4B, after marks or harms made on the surface of the semiconductor substrate 10 in the cutting process are removed, texturing is performed to form fine concavo-convexes in the surface of the semiconductor substrate 100. The process of removing the marks or harms made on the surface of the semiconductor substrate 10 may be carried out by wet etching using an alkaline solution. The concavo-convexes may be formed using a scratching process that forms a stripped pattern. The concavo-convexes are formed to widen a region which sunlight reaches to reduce reflectance, and the pattern of the concavo-convexes is not limited.

Successively, referring to FIG. 4C, impurities such as phosphorous are injected into the semiconductor substrate 10a in whose surface fine concavo-convexes have been formed and then heat treatment is performed at a predetermined temperature. As a result, the impurities injected into the surface of the semiconductor substrate 10a are diffused into the inside of the semiconductor substrate 10a, so that a diffusion layer 20 having a predetermined thickness is formed in the semiconductor substrate 10a. The process of forming the diffusion layer 20 is aimed at making the semiconductor substrate 10a have conductivity. Then, an etching process may be performed to remove a thin film, for example, a PhospoSilicate Glass (PSG) film, etc. made during the injection of impurities and heat treatment. FIG. 4C shows the state of the semiconductor substrate 10b after a PSG film, etc. is removed.

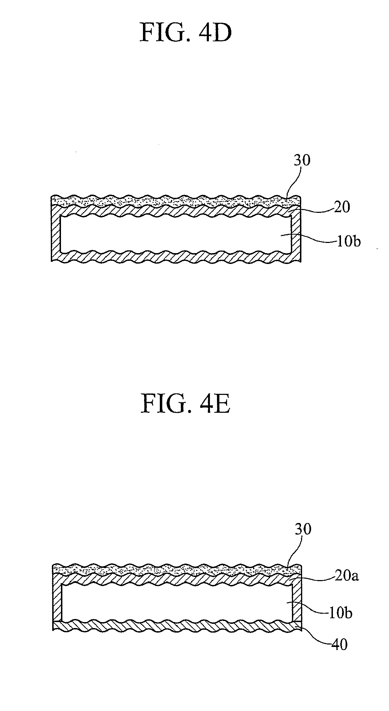

Then, referring to FIG. 4D, an anti-reflection coating 30 is formed on the front side of the semiconductor substrate 10b, that is, on the light-receiving surface of the semiconductor substrate 10b. The anti-reflection coating 30 may be formed with a constant thickness. As a result, the same fine concavo-convexes as those formed on the semiconductor substrate 10b are formed on the anti-reflection coating 30. The anti-reflection coating 30 may be formed with SiNₓ, but not limited to this. A process of forming the anti-reflection coating 30 is not limited, for example, the anti-reflection coating 30 may be formed using a PECVD process.

Referring to FIG. 4E, the diffusion layer formed on the back side of the semiconductor substrate 10b, that is, on the light-receiving surface of the semiconductor substrate 10b is removed. As a result, the diffusion layer 20a remains only on the front and lateral sides of the semiconductor substrate 10b. Then, a BSF layer 40 is formed with AlO, AlON or AlON on the back side of the p-type silicon substrate 10b from which the diffusion layer 20 has been removed. In FIG. 4E, the BSF layer 40 is formed in the state where the back side of the semiconductor substrate 10b is disposed toward the downward, however, the disposition of FIG. 4 is to match the up-down direction with the other drawings (FIGS. 4A through 4D). In the actual process, it is also possible that the back side of the semiconductor substrate 10b is disposed toward the upward and the BSF layer 40 is formed on the back side of the semiconductor substrate 10b.

As described above, when the BSF layer 40 is formed with AlO, a process for forming a protective layer 35 on the back side of the semiconductor substrate 10b before forming an AlO film may be additionally performed. The protective layer 35 may be formed with a material such as oxide having an excellent passivation property. For example, in order to form an oxide film having excellent quality, a thermal CVD process may be performed at a high temperature above 900°C, but this may deteriorate the characteristics of other membranes. Accordingly, the thermal CVD process may be performed at an appropriate temperature that can avoid deterioration of other membranes.

In the current example, the thermal CVD process has to be performed at a predetermined process temperature such that the BSF layer 40, for example, the AlO, AlN or AlON film has a sufficient NFC characteristic. The reason is because the AlO, AlN and AlON films do not always have the NFC characteristic but have the NFC characteristic only when they are formed at a specific process temperature range. In more detail, the AlO, AlN or AlON film has the NFC characteristic only when it is formed at a predetermined temperature range, for example, at a range from 150°C to 400°C using the CVD or ALD process. The AlO, AlN or AlON film has no NFC characteristic at a temperature range above 400°C or below 150°C.

As such, the AlO, AlN or AlON film may be formed using the CVD or ALD process. A process gas for forming an AlO film, that is, a source gas may be trimethylaluminum (TMA, Al(CH3)3). If O₃ is used as a reactant gas that is oxidant, the ALD process is more effective than the CVD process. The reason is because when the CVD process is used, TMA and O₃ are combined due to their high reactivity before diffusing into the substrate to thus deteriorate uniformity of an AlO film that is to be deposited. Meanwhile, when the ALD process is used, an atomic monolayer of the source gas is absorbed onto the substrate, the reactant gas is absorbed onto the source gas layer and thereafter reaction is preformed, so that uniformity of an AlO film that is deposited becomes excellent.

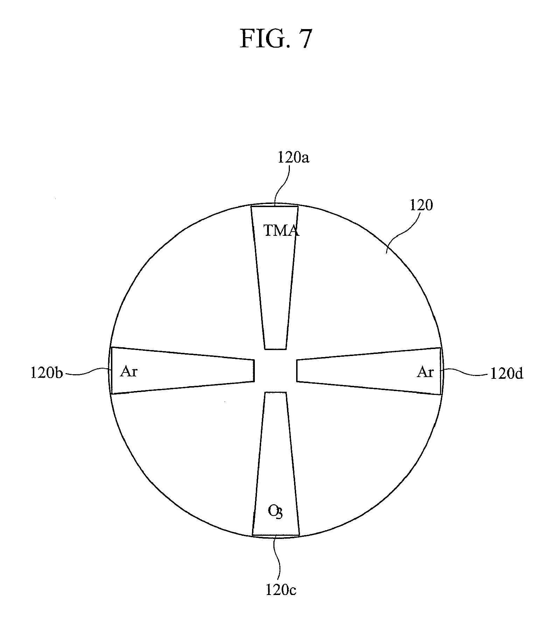

However, when the AlO film is formed using the ALD process, there are difficulties in implementing high productivity due to a low deposition rate of the ALD process. When the AlO film is formed using the ALD process in the multiple substrate processing apparatus (see FIGS. 7, 8, 9A, 9B, 10A and 10B), productivity can be improved to a certain level but this is not a fundamental solution. Furthermore, such a multiple substrate processing apparatus is expensive compared to a single substrate processing apparatus, has a complicated structure and also has difficulties in controlling processes to form uniform layers.

The drawbacks of the ALD process can be overcome by using the PECVD or PEALD process that can achieve a relatively high deposition rate. In other words, by forming the AlO film using the PECVD or PEALD process, significantly higher productivity can be obtained than the case of using the ALD process. However, a general PECVD process in which plasma is formed between a shower head and a substrate support, that is, in a processing space of a chamber may damage the semiconductor substrate due to the plasma. In more detail, membranes may be degraded due to the straightness and ion bombardment of plasma.
Damages made on the surface of the semiconductor substrate due to the plasma generates defaults in the interface with the AlO film, which may deteriorate the property of the AlO film as a BSF layer.

A method for increasing a deposition rate while maintaining the property of a layer such as the AlO film uses the RA-CVD or RA-ALD process instead of the general PECVD, PEALD or CVD process. In this specification, the "RA-CVD" or "RA-ALD" process is a method in which plasma is created in the shower head, not in the space between the shower head and the substrate support. That is, the RA-CVD or RA-ALD process plasmarizes a process gas in the shower head and then supplies the plasmarized process gas into a processing space, unlike a direct plasma method of plasmarizing a process gas in a processing space between the shower head and substrate support or a remote plasma method of receiving a plasmarized process gas from the outside of a substrate processing apparatus. The RA-CVD or RA-ALD process is used to prevent layers from being damaged, as well as increasing a deposition rate compared to the general CVD or ALD process.

Also, the RA-CVD or RA-ALD process may plasmarize only the reactant gas in the shower head and then supply the plasmarized reactant gas into a processing space, instead of plasmarizing both the source gas and reactant gas (hereinafter, the "source gas" and "reactant gas" are wholly referred to as a "raw material gas") and supplying them into the processing space. At this time, the source gas may be supplied into the processing space, separately from the reactant gas. Accordingly, it is possible to prevent a source gas from reacting with a reactant gas inside a shower head or at a location that is distant away from a substrate and to facilitate active chemical reaction on the surface of the substrate. As a result, a high deposition rate and excellent reactivity are achieved which can improve the membrane of an AlO film to be deposited.

The process of forming the AlO, AlN or AlON film using the above-described CVD, ALD, RA-CVD or RA-ALD process may be performed in the single substrate substrate apparatus or in the multiple substrate processing apparatus of processing a plurality of substrates simultaneously. Specifically, in the case where the process is performed in the multiple substrate processing apparatus, the process may be performed in a multiple substrate processing apparatus, including a substrate support on whose upper side the plurality of substrates are mounted along the circumference and a shower head in which gas injection holes are grouped into several gas injection parts. In the this case, the process of forming an AlO film, etc. may be performed in a specific multiple substrate processing apparatus, in which at least one of a substrate support and a shower head is relatively rotated with respect to the other one during the process.

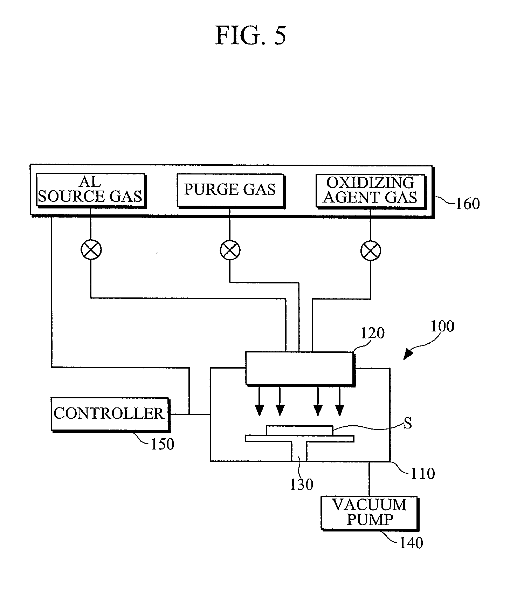

FIG. 5 illustrates an example of a substrate processing apparatus for fabricating solar cells (hereinafter, simply referred to as a "substrate processing apparatus"), which can be used to form AlO films using the ALD process. Referring to FIG. 5, the substrate processing apparatus 100 includes a processing chamber 110, a shower head assembly 120, a substrate support 130, an vacuum pump 140, a controller 150 and a gas supply unit 160.

The processing chamber 110 includes a deposition space where the ALD process is performed. The processing chamber 110 may further include a heater (not shown) and/or cooler for adjusting the inner temperature of the processing chamber 110, and a plasma generating unit (not shown). For example, the plasma generating unit may be needed in order to increase the reactivity of an oxidizing agent gas when Oxygen, NO, H₂O₂, etc. are used as the oxidizing agent gas in the ALD process.

The shower head assembly 120 is used to uniformly inject a process gas supplied from the gas supplying unit 160 into the processing chamber 110. A plurality of injection holes may be formed in the lower side of the shower head assembly 120. Process gases, for example, an Al source gas, a purge gas and an oxidizing agent gas are sequentially supplied to the shower head assembly 120 from the gas supply unit 160 connected to the upper side of the shower head assembly 120 through gas supply pipes. The vacuum pump 140 is used to make the inner space of the processing chamber 110 vacuous or discharge a process gas remaining after being deposited on a semiconductor substrate to the outside.

The substrate support 130 is used to mount and support semiconductor substrates that are to be processed. The substrate support 130 is also called a susceptor. In the single substrate processing apparatus, a single semiconductor substrate S to be processed is loaded on the substrate support 130, however, it is apparent to one of ordinary skill in the art that the current example can be applied to a multiple substrate processing apparatus. Also, a heater, etc. (not shown) for raising the temperature of a semiconductor substrate S to be processed up to a predetermined processing temperature may be included in the substrate support 130. The heater may be installed in or positioned below the substrate support 120, inside the processing chamber 1100.

The controller 120 controls processing parameters required to form an AlO film using the ALD process. For example, the controller 150 controls the gas supply unit 160 to adjust the kind, flow rate, inflow time, etc. of a process gas to flow into the processing chamber 110, and controls the temperature of a semiconductor substrate S to be processed as well as the inner temperature of the processing chamber 110. For example, the controller 150 may use the heater, etc. included in the substrate support 130 to control the temperature of a substrate such that an AlO film is deposited at a substrate temperature between 150°C and 400°C using the ALD process. Also, the vacuum pump 140 or the plasma generating unit may be controlled by the controller 150.

The substrate processing apparatus 100 may form the AlO, AlN or AlON film using the following method. A method of forming an AlO film using the ALD process in the substrate processing apparatus 100 may be applied to a multiple substrate processing apparatus, as well as a single substrate processing apparatus. Also, the method of forming an AlO film using the ALD process in the substrate processing apparatus 100 may be applied to a method of forming an AlN film by using compound with nitrogen such as NH₃ or a nitriding agent gas such as N as a reactant gas. The method of forming the AlO film using the ALD process may be also applied to the method of forming the AlON film by configuring a process cycle in the order of a source gas, a first purge gas, a first reactant gas (one of an oxidizing agent gas and a nitriding agent gas), a second purge gas, a second reactant gas (the other one of the oxidizing agent gas and nitriding agent gas) and a third purge gas.

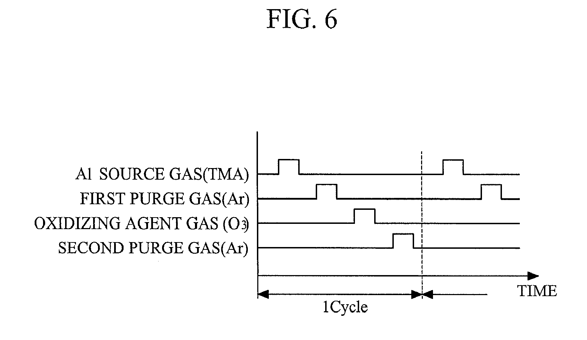

FIG. 6 is a timing chart regarding process gases for forming an AlO film using the ALD process. The AlO film is formed in the state where the back side of a semiconductor substrate S (in more detail, the resultant substrate on which the processes illustrated in FIGS. 4A though 4D have been performed) faces upward on a substrate support in a processing chamber.

Referring to FIGS. 5 and 6, an Al source gas which is one of raw material gases is injected toward the semiconductor substrate S through the shower head 120. The Al source gas may be TMA, however, not limited to this. For example, the Al source gas may be aluminum trichloride (AlCl₃), triethylaluminium (TEA), clorodimethylaluminium (Me₂AlCl), aluminum ethoxide, aluminum isopropoxide, tri isobutyl aluminum, demethylaluminum hydride, trimethylamine alein, triehylamine alein, demethyletylamine alien, etc. When TMA having high steam pressure even at a low temperature is used as the Al source gas, the TMA may be injected onto the semiconductor substrate S by pressure made by pushing Ar into a canister at a flow rate of 100sccm.

Then, the first purge gas is injected onto the semiconductor substrate S through the shower head 120. Then, the vacuum pump 140 is driven to discharge the first purge gas and the remaining Al source gas except for an atomic monolayer of the Al source gas absorbed onto the semiconductor substrate S to the outside. The first purge gas may be an inert gas, for example, Ar. However, any other gas may be used as the first purge gas. The Ar gas may be sprayed at a flow rate of 300sccm.

Then, the reactant gas which is the other one of the raw material gases, that is, an oxidizing agent gas (for example, O₃) is injected on the semiconductor substrate S at a flow rate of 90sccm. When an AlN film is formed, a nitriding agent gas, for example, ammonia is supplied and when an AlON film is formed, an oxidizing agent gas and a nitriding agent gas are sequentially (or in the order of a nitriding agent gas and an oxidizing agent gas) supplied. A purge gas may be additionally supplied before the nitriding agent gas is supplied after the oxidizing agent gas is supplied. The oxidizing agent gas is deposited on the semiconductor substrate S to react with the Al source gas, so that an atomic monolayer of Al oxide (AlO) is formed on the semiconductor substrate S. N₂O, O₂ or H₂O₂ other than O₃ may be used as the oxidizing agent. Other oxidizing agents than O₃ having high reactivity are excited to a plasma state and then supplied as a reactant gas. The plasma may be direct plasma or remote plasma, however, any other plasma may be used. H₂O may be used as the oxidizing agent and in this case, a vaporizer may be used.

Subsequently, an inert gas is injected as the second purge gas on the semiconductor substrate S through the shower head 120. The second purge gas may be Ar and the Ar gas may be sprayed at a flow rate of 300sccm. After the second purge gas is sprayed, the remaining oxidizing agent and reaction by-products are discharged outside the processing chamber 110.

After the above-described processes are performed, one process cycle of the ALD process is completed. The thickness of an AlO film to be deposited may be adjusted depending on how many times the process cycles are repeated.

As described above, the process of forming the AlO, AlN or ALON film may be performed in the multiple substrate processing apparatus to fabricate solar cells (hereinafter, simply referred to as a multiple substrate processing apparatus). In the multiple substrate processing apparatus, a plurality of substrates are individually arranged or grouped into several groups and then arranged along the circumference of a substrate support, and thereafter a process of depositing an AlO, AlN or AlON film is performed.

For example, after a plurality of semiconductor substrates are loaded on the substrate support, a cycle of sequentially injecting the Al source gas, the first purge gas, the oxidizing agent gas or nitriding agent gas and the second purge gas is repeated by a predetermined number of times so as to form an AlO or AlN film with a desired thickness. Or, by repeating a cycle of sequentially injecting the Al source gas, the first purge gas, the oxidizing gas (or the nitriding agent gas), the second purge gas, the nitriding agent gas (or the oxidizing gas) and the fourth purge gas by a predetermined number of times, an AlON film may be formed with a desired thickness. In this case, the process may be performed after the substrate support and the shower head are fixed or while the substrate support and the shower head are rotated with respect to each other. In the case where gas injection holes of the shower head are grouped into several gas injection parts, the process gases may be sequentially injected or a part of the process gases may be injected through the corresponding ones of the gas injection parts. In the latter case, by relatively rotating the substrate support with respect to the shower head, an AlO film may be uniformly deposited on the entire surface of the loaded semiconductor substrate.

Or, when a plurality of semiconductor substrates are loaded on the substrate support, the respective process gases are simultaneously injected through the injection holes of the shower head grouped into several gas injection parts. For example, when an AlO film is formed, as illustrated in FIG. 7, TMA which is one of Al source gases is injected through injection holes of a first gas injection part 120b, an Ar gas which is a purge gas is injected through injection holes of a second gas injection part 120b, a O₃ gas which is an oxidizing agent reactant gas is injected through a third gas injection part 120c and an Ar gas which is also a purge gas is injected through a fourth gas injection part 120d. In this case, since the substrate support is relatively rotated with respect to the shower head (in the example illustrated in FIG. 7, only the substrate support is rotated in a couterclockwise direction), a one-time rotation of the substrate support achieves the same effect as one cycle of the ALD process. Accordingly, a fabricating time is reduced compared to the above-described time division ALD method, resulting in an increase of a yield.

Meanwhile, when a nitriding agent reactant gas is injected instead of an oxidizing agent reactant gas in the example illustrated in FIG. 7, an AlN film may be formed by simultaneously injecting process gases through the gas injection parts of the shower head. Here, the gas injection holes of the shower head may be grouped into 6 or 8 gas injection parts. Meanwhile, an AlON film may be formed by simultaneously injecting the process gases in the order of the Al source gas, the first purge gas, the oxidizing agent gas (or the nitriding agent gas), the second purge gas, the nitriding agent gas (or the oxidizing agent gas) and the third purge gas through the 6 gas injection parts or by simultaneously injecting process gases in the order of the Al source gas, the first purge gas, the oxidizing agent gas (or the nitriding agent gas), the second purge gas, the Al source gas, the third purge gas, the nitriding agent gas (or the oxidizing agent gas) and the fourth purge gas.

In the process of depositing the AlO, AlN or AlON film using the multiple substrate processing apparatus, a flow rate of each gas injected from the shower head may be adaptively decided in consideration of various conditions. For example, it is possible to increase the flow rate of each gas in proportion to the number of semiconductor substrates that are loaded on the substrate support. The flow rate of each gas may depend on the rotation speed of the substrate support, a processing temperature, the number of the gas injection units, the number or arrangement of injection holes of a gas injection unit, etc.

An example of the multiple substrate processing apparatus is disclosed in Korean Patent Application No. 2008-0125368 entitled "Apparatus for treatment of plural substrates", filed on December 10, 2008, by the same applicant. In the apparatus for treatment of plural substrates, at least one of the substrate support and shower head is relatively rotated with respect to the other one and the entire disclosure of the specification is incorporated herein by reference for all purposes.

The apparatus of treatment of plural substrates disclosed in the Korean Patent Application No. 2008-0125368 includes a processing chamber, a substrate support, a heater, a shower head assembly, a gas supply unit and an vacuum pump. The substrate support is installed in the processing chamber and supports one or more semiconductor substrates each having a light-receiving surface. The heater heats semiconductor substrates that are mounted on the substrate support. The shower head assembly is installed in the upper side of a substrate support inside the processing chamber and injects a process gas supplied from the gas supply unit to a deposition space through a plurality of injection holes formed in the lower side of the shower head assembly. The vacuum pump makes the inner space of the processing chamber vacuous or discharges the remaining process gases or reaction by-products outside the processing chamber. The apparatus for treatment of plural substrates further includes a controller. When an AlO or AlN film is formed, the controller may control the gas supply unit such that an Al source gas, a first purge gas, an oxidizing or nitriding agent gas and a second purge gas are injected into a deposition space, and simultaneously control the heater such that the temperature of a semiconductor substrate is within a range of 150 - 400°C. Meanwhile, when an AlON film is formed, the controller may control the gas supply unit such that an Al source gas, a first purge gas, an oxidizing or nitriding agent gas, an Al source gas, a second purge gas, a nitriding (or oxidizing) agent gas and a third purge gas are injected into a deposition space, and simultaneously control the heater such that the temperature of the semiconductor substrate is within a range of 150 - 400°C .

The shower head assembly may have a structure in which different process gases are sequentially sprayed through the entire injection holes. Also, there is further provided a rotation driver to rotate at least one of the substrate support and the shower head assembly such that the substrate support and the shower head assembly are rotated with respect to each other. The shower head assembly may include a plurality of raw material gas (process gases and reactant gases) injection units which are disposed along the circumference of the substrate support to supply different kinds of raw material gases to the substrate support, and a plurality of purge gas injection units which are disposed between raw gas injection units that inject different kinds of raw material gases to purge raw material gases on the substrate support. In this case, the shower head assembly may further include a central purge gas injection unit to supply a purge gas for purging raw material gases. The central purge gas injection unit may be disposed in the center of the shower assembly. Or, in the shower head assembly, a plurality of gas injection blocks are configured in such a manner that adjacent two or more ones among the raw material gas injection units and the purge gas injection units, the adjacent gas injection units injecting the same kind of gas, are grouped into a gas injection block. Additionally, buffer units which inject no gas may be respectively disposed between the raw material gas injection units and the purge gas injection units.

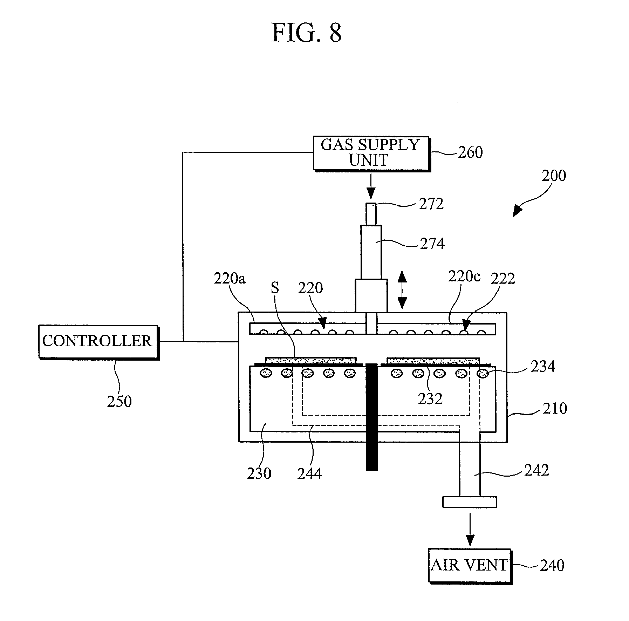

FIG. 8 illustrates an example of a multiple substrate processing apparatus 200.

Referring to FIG. 8, the multiple substrate processing apparatus 200 includes a processing chamber 210 having a deposition space, a shower head assembly having a plurality of injection holes 333 opened toward substrates S, susceptors 232, a susceptor support 230, an air vent 240 such as an vacuum pump, a controller 250 and a gas supply unit 260. The susceptors 232 mounted on the susceptor support 230 may be four and a semiconductor substrate S may be placed on each susceptor 232. Process gases and reaction by-products are discharged to the outside via a through hole 244 and a gas outlet 242 that are formed in the susceptor support 230 to connect to the inner space of the processing chamber 210. Heaters 234 for heating the substrates S are buried in the susceptor support 230. The controller 250 controls the gas supply unit 260 and the heaters 234 such that the temperature of the substrates S is within a range of 150 - 400 °C when the ALD process for forming AlO films on the substrates S are performed.

A rotatable gas injection unit may be installed over the processing chamber 210. The rotatable gas injection unit may include, for example, a cylinder 264, a rotating shaft 272 installed in the cylinder 274 and a propeller-type gas injection unit (not shown). When a deposition process is performed, the propeller-type gas injection unit is rotated to inject process gases and purge gases toward a deposition space. According to an example, an elevating unit for moving the susceptor support 230 and/or the rotating shaft 272 in a up-down direction may be provided in order to adjust the distance between the propeller-type gas injection unit and the susceptors 232.

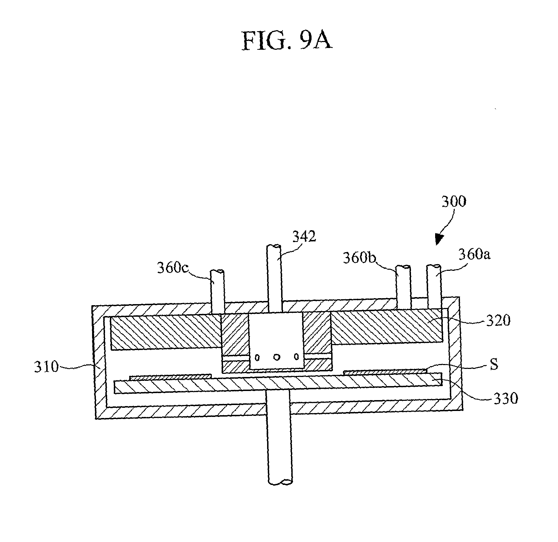

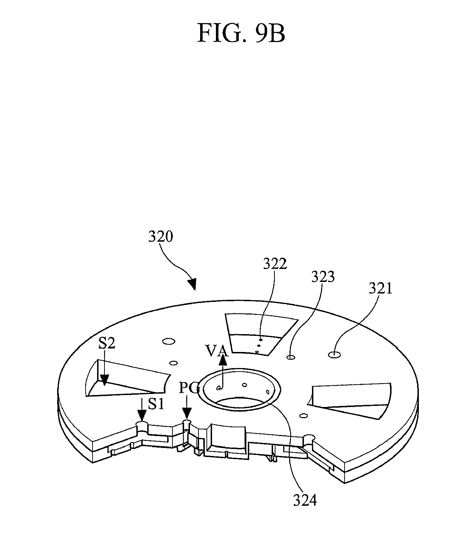

FIGS. 9A and 9B illustrate a structure of the multiple substrate processing apparatus 300. Referring to FIGS. 9A and 9B, the multiple substrate processing apparatus 300 includes a processing chamber 310 having a deposition space, into which the substrates are loaded, a shower head assembly 320 and a substrate support 330 which supports the substrates S. Different kinds of sources gases are supplied to the shower head assembly 320 through different gas supply pipes 360a and 360b, and a purge gas is also supplied to the shower head assembly 320 through gas supply pipes 360c. A hole-shaped air vent 324 is formed in the center of the shower head assembly 320 and a gas outlet 324 is connected to the hole-shaped air vent 324 to discharge an exhaust gas to the outside.

Also, the shower head assembly 320 includes a plurality of source gas injection units 321 and 322 for injecting different kinds of source gases S1 and S2 and a plurality of purge gas injection units 323 for injecting a purge gas PG on the substrates S, wherein the source gas injection units are connected to the gas supply pipes 360a and 360b and the purge gas injection units 323 are connected to the gas supply pipe 360c. The purge gas PG that is injected through the purge gas injection units 323 forms an air curtain between different kinds of source gases S 1 and S2 that are injected through the source gas injection units 321 and 322, thus preventing the different kinds of source gases S 1 and S2 from reacting with each other before contacting the substrates S. The purge gas PG may be injected at a certain angle with respect to the substrates S. The source gas injection units 321 and 322 may be alternately arranged to inject different kinds of source gases along a radial direction, and each of the purge gas injection units 232 may be positioned between two source gas injection units 321 and 322.

Although not shown in the drawings, the multiple substrate processing apparatus 300 further includes heaters for heating a plurality of substrates S up to a predetermined temperature. The apparatus 300 of processing the substrates S further includes a controller for controlling the heaters and a gas supply unit connected to the gas supply pipes 360a, 360b and 360c.

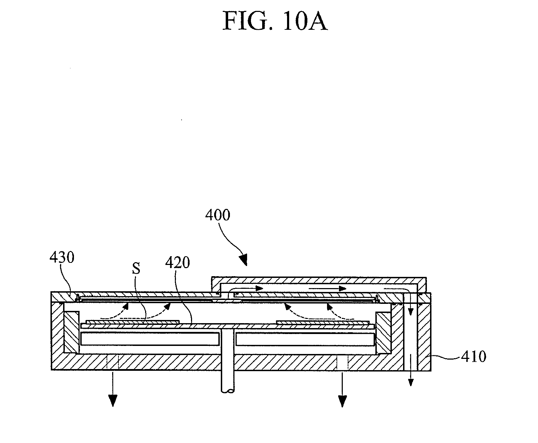

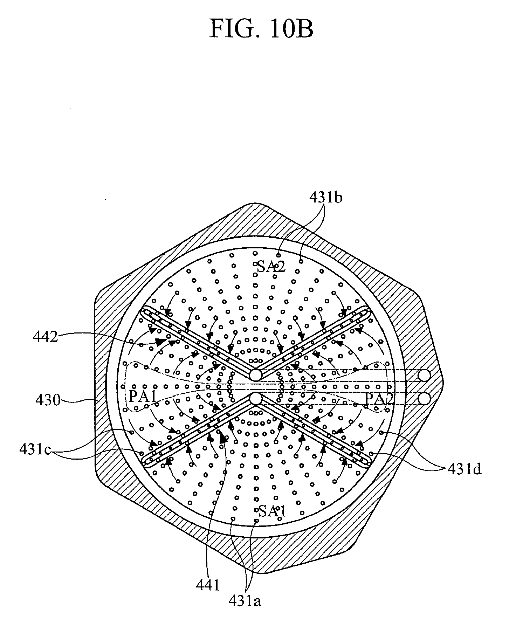

FIGS. 10A and 10B illustrate a structure of another example of a multiple substrate processing apparatus 400, wherein FIG. 10B is a cross-sectional view of a shower head assembly 430 of the apparatus 400. Referring to FIGS. 10A and 10B, the multiple substrate processing apparatus 400 includes a processing chamber 410 having a deposition space, into which a plurality of substrates S are loaded, a substrate support 420 which supports the substrates S, a shower head assembly 430 and a separating and venting device (not shown). The separating and venting device may be disposed in or below the shower head assembly 430.

Gas injection holes 431a through 431d for supplying gases are formed in the shower head assembly 430. The gas injection holes 431a through 431d include first and second source gas injection holes 431a and 431b and first and second purge gas injection holes 431c and 431d. The first and second source gas injection holes 431a and 431b are formed in first and second source gas regions SA1 and SA2 and the first and second purge gas injection holes 431c and 431d are formed in first and second purge gas regions PA1 and PA2. The source gas injection holes 431a and 431b and the purge gas injection holes 431c and 431d are partitioned by first and second source gas air vent lines 441 and 442 of the separating and venting device. That is, the first and second source gas air vent lines 441 and 442 are disposed between the source gas injection holes 431a and 431b and the purge gas injection holes 431c and 431d. By the first and second source gas air vent lines 441 and 442, the inner space of the reaction chamber 410 is also partitioned into the first and second source gas regions SA1 and SA2 and the first and second purge gas regions PA1 and PA2.

Although not shown in the drawings, the multiple substrate processing apparatus 400 includes a gas supply unit for supplying source gases and purge gases and heaters for heating the substrates S up to a predetermined temperature. The multiple substrate processing apparatus 400 further includes a controller for controlling the heaters and the gas supply unit.

It is apparent to one of ordinary skill in the art that the current example can be applied to various types of multiple substrate processing apparatuses other than the above-described multiple substrate processing apparatus. For example, the above-described processes may be performed in an arbitrary multiple substrate processing apparatus, including a processing chamber having a deposition space, a substrate support rotatably installed in the processing chamber, on which at least one substrate is mounted, a gas supply unit provided over the processing chamber to supply different kinds of gases into the processing chamber, a separating and venting device formed in the substrate support at a location corresponding to the boundaries of regions to which different kinds of gases are supplied, the separating and venting device including air vent lines for exhausting peripheral gases, and an vacuum pump providing the separating and venting device with an absorption force. The multiple substrate processing apparatus includes a controller for controlling the temperature of substrates and gas supply.

As described above, a solar cell A illustrated in FIG. 1 is fabricated by forming an AlO film 40 with a predetermined thickness on the back side of a p-type silicon substrate 10b (see FIG. 4E), then forming a upper electrode pattern 52 and a back surface electrode 54 and removing PSG films, etc. formed on lateral parts of the semiconductor substrate 10b.

In this case, before forming the back surface electrode 54, a capping layer (not shown) may be further formed on the AlO film 40. In more detail, the capping layer may be formed with an insulating material, such as silicon nitride, silicon oxide, silicon oxynitride, or the like. Then, a via hole is formed in the capping layer using a laser or any other etching process, in order to ensure an electrical connection path between the AlO film 40 and the back surface electrode 54. Successively, Al paste is applied on the capping layer to form a back surface electrode 54 and then heat treatment, etc. is performed.

As described above, in the solar cell A, a BSF layer having the higher NFC characteristic than an existing BSF layer formed with Al paste is formed with AlO, AlN or AlON on the opposite surface of the light-receiving surface of a p-type semiconductor substrate. Accordingly, the solar cell A may lengthen the lifetime of electrons generated by absorbing light and avoid loss due to the recombination of electrons with holes in the back side. Also, when the BSF layer is formed with AlO, the efficiency of the solar cell A may be further improved by forming a protective layer in the interface between the BSF layer and the p-type semiconductor substrate. Also, when the BSF layer is formed with Al nitride and/or Al oxynitirde, the solar cell A may have high efficiency without forming any protective layer. Furthermore, according to the above-described examples, in the semiconductor substrate, internal reflection of photons having a long wavelength above 900nm increases to lengthen the moving path of the photons, thereby improving both EQE and IQE.

A number of examples have been described above. Nevertheless, it will be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

A solar cell and a fabricating method thereof are provided. In the method of fabricating the solar cell, a p-type semiconductor substrate on whose light-receiving surface an anti-reflection coating is formed is loaded into a processing chamber. In this case, the p-type semiconductor substrate may be loaded on a substrate support of an apparatus of processing a plurality of substrates along the circumference of the substrate support, in the state where the back surface of the p-type semiconductor substrate faces upward. Then, a back surface field (BSF) layer having the characteristic of Negative Fixed Charge (NFC) is formed with AlO, AlN or ALON on the back surface of the p-type semiconductor substrate. At this time, the BSF layer may be formed by simultaneously injecting an Al source gas, a first purge gas, an oxidizing agent gas and/or a ntiriding agent gas, and a second purge gas through injection holes of individual gas injection units while relatively rotating the substrate support with respect to the shower head. Thereafter, a back surface electrode is formed on the BSF layer such that the back surface electrode is electrically connected to the BSF layer.

## Claims

1. A method of fabricating a solar cell comprising:
preparing a p-type semiconductor substrate;
forming a back surface field (BSF) layer with Al compound on an opposite surface of a light-receiving surface of the p-type semiconductor substrate; and
forming a back surface electrode on the BSF layer to electrically connect to the BSF layer.

2. The method of claim 1, wherein the BSF layer comprises at least one film among an AlO film, an AlN film and an AlON film, and
the AlO film, the AlN film and the AlON film are formed by performing deposition within a temperature range of 150 - 400°C using an Atomic Layer Deposition (ALD) or Chemical Vapor Deposition (CVD) process.

3. The method of claim 2, wherein the forming of the BSF layer comprises:
loading at least one substrate on a substrate support disposed in a processing chamber; and
repeatedly performing a process of sequentially injecting an Al source gas, a first purge gas, an oxidizing or nitriding agent gas, and a second purge gas from over the substrate support to deposit the AlO film or the AlN film.

4. The method of claim 2, wherein the forming of the BSF layer comprises:
loading at least one substrate on a substrate support placed in the processing chamber; and
repeatedly performing a process of sequentially injecting an Al source gas, a first purge gas, one of an oxidizing agent gas and a nitriding agent gas, a second purge gas, the other one of the oxidizing agent gas and the nitriding agent gas, and a third purge gas from over the substrate support to deposit the AlON film.

5. The method of claim 2, wherein the forming of the BSF layer comprises:
loading at least one substrate on a substrate support placed in the processing chamber; and
repeatedly performing a process of sequentially injecting an Al source gas, a first purge gas, one of an oxidizing agent gas and a nitriding agent gas, a second purge gas, the Al source gas, a third purge gas, the other one of the oxidizing agent gas and the nitriding agent gas, and a fourth purge gas from over the substrate support to deposit the AlON film.

6. The method of claim 2, wherein the forming of the BSF layer comprises:
loading a plurality of substrates on a substrate support placed in the processing chamber along a circumference of the substrate support; and
repeatedly performing a process of simultaneously injecting an Al source gas, a first purge gas, an oxidizing or nitriding agent gas and a second purge gas from a shower head provided over the substrate support while relatively rotating the substrate support with respect to the shower head, the shower head including a plurality of gas injection units, to deposit the AlO film or the AlN film.

7. The method of claim 2, wherein the forming of the BSF layer comprises:
loading a plurality of substrates on a substrate support placed in the processing chamber along a circumference of the substrate support; and
repeatedly performing a process of simultaneously injecting an Al source gas, a first purge gas, one of an oxidizing agent gas and a nitriding agent gas, a second purge gas, the other one of the oxidizing agent gas and the nitriding agent gas, and a third purge gas from a shower head provided over the substrate support while relatively rotating the substrate support with respect to the shower head, the shower head including a plurality of gas injection units, to deposit the AlON film.

8. The method of claim 2, wherein the forming of the BSF layer comprises:
loading a plurality of substrates on a substrate support placed in the processing chamber along a circumference of the substrate support; and
repeatedly performing a process of simultaneously injecting an Al source gas, a first purge gas, one of an oxidizing agent gas and a nitriding agent gas, a second purge gas, the Al source gas, a third purge gas, the other one of the oxidizing agent gas and the nitriding agent gas, and a fourth purge gas from a shower head provided over the substrate support while relatively rotating the substrate support with respect to the shower head, the shower head including a plurality of gas injection units, to deposit the AlON film.

9. The method of any one of claim 3, wherein the Al source gas comprises at least one selected from a group consisting of trimethylaluminum (TMA), aluminum trichloride (AlCl₃), triethylaluminium (TEA), clorodimethylaluminium (Me₂AlCl), aluminum ethoxide, aluminum isopropoxide, tri isobutyl aluminum, demethylaluminum hydride, trimethylamine alein, triehylamine alein, and demethyletylamine alien.

10. The method of any one of claim 3, wherein the oxidizing agent gas comprises one selected from a group consisting of O₃, N₂O, O₂ and H₂O₂, and
the nitriding agent gas is NH₃ or N₂.

11. A substrate processing apparatus for fabricating a solar cell, comprising:
a processing chamber having a processing space therein;
a substrate support installed in the processing chamber, to support one or more semiconductor substrates each having a light-receiving surface;
a heater to heat the one or more semiconductor substrates arranged on the substrate support;
a shower head assembly provided over the substrate support, to inject a process gas into a deposition space through a plurality of injecting holes formed in a lower part of the shower head assembly;
a gas supply unit to supply the process gas to the shower head assembly;
an vacuum pump to make an inner space of the processing chamber vacuous or to discharge a remaining process gas or a reaction by-products outside the processing chamber; and
a controller to control the gas supply unit to inject an Al source gas, a first purge gas, one or both of an oxidizing agent gas and a nitriding agent gas, and a second purge gas to the processing space, and to control the heater such that a temperature of the semiconductor substrate is within a range of 150 - 400 °C.

12. The substrate processing apparatus of claim 11, wherein the shower head assembly has a structure in which different kinds of process gases are sequentially injected through a plurality of injection holes.

13. The substrate processing apparatus of claim 11, further comprising a rotation driver to rotate at least one of the substrate support and the shower head assembly such that the substrate support and the shower head assembly rotate with respect to each other,
wherein the shower head assembly comprises:
a plurality of raw material gas injection units arranged along a circumference of the substrate support to supply different kinds of raw material gases on the substrate support; and
a plurality of purge gas injection units respectively disposed between raw material gas injection units for injecting different kinds of raw material gases among the plurality of raw material gas injection units, to purge a raw material gas injected on the substrate support.

14. The substrate processing apparatus of claim 13, wherein the shower head assembly further comprises a central purge gas injection unit disposed in a center of the shower head assembly, to supply a purge gas.

15. The substrate processing apparatus of claim 13, wherein in the shower head assembly, a plurality of gas injection blocks are configured in such a manner that adjacent two or more injection units among the raw material gas injection units and the purge gas injection units, the adjacent gas injection units injecting the same kind of gas, are grouped into a gas injection block.
